# EUROPÄISCHE PATENTSCHRIFT

(11) **EP 1 743 417 B1**
(45) Veröffentlichungstag und Bekanntmachung des Hinweises auf die Patenterteilung: **11.04.2018**
(21) Anmeldenummer: 05716783.5
(22) Anmeldetag: 24.02.2005
(51) Int. Cl.: H02P 9/00, H02J 7/14

(54) **MONOLITHISCHER REGLER FÜR DIE GENERATOREINHEIT EINES KRAFTFAHRZEUGS**
MONOLITHIC CONTROLLER FOR THE GENERATOR UNIT OF A MOTOR VEHICLE
REGULATEUR MONOLITHIQUE POUR L'UNITE GENERATRICE D'UNE AUTOMOBILE

(30) Priorität: 24.04.2004 DE 102004020172
(43) Veröffentlichungstag der Anmeldung: 17.01.2007
(73) Patentinhaber: SEG Automotive Germany GmbH, 70499 Stuttgart (DE)
(72) Erfinder: HENKEL, Achim, 72766 Reutlingen (DE); KOELSCH, Volker, 70599 Stuttgart (DE); MILICH, Reinhard, 72770 Reutlingen (DE)
(74) Vertreter: Steinbauer, Florian
(86) Internationale Anmeldenummer: PCT/EP2005/050783
(87) Internationale Veröffentlichungsnummer: WO 2005/104345

(56) Entgegenhaltungen:
- EP-A- 0 258 691
- EP-A- 1 130 766
- DE-A1- 10 228 666
- US-A- 4 310 792

## Beschreibung

Die Erfindung betrifft einen monolithischen Regler für die Generatoreinheit eines Kraftfahrzeugs.

### Stand der Technik

Aus der DE 101 50 380 A1 ist eine Energieversorgung mit redundanter Generatorregelung für Kraftfahrzeuge bekannt. Diese bekannte Energieversorgung, die insbesondere zur Energieversorgung von Kraftfahrzeug-Bordnetzen vorgesehen ist, weist eine Batterie auf, an welche mehrere Verbraucher angeschlossen sind. Weiterhin ist sie mit einem Generator zum Aufladen der Batterie und einem Regler zur Regelung der Generatorspannung ausgestattet. Der Regler weist einen Controller, einen vom Controller angesteuerten ersten Schalter zur Regelung der Generatorspannung im Normalbetrieb und einen vom Controller ansteuerbaren zweiten Schalter zur Regelung der Generatorspannung bei einer Fehlfunktion des ersten Schalters auf.

Regler für die Generatoreinheit eines Kraftfahrzeugs müssen zunehmend höheren Anforderungen in Bezug auf die Impulsfestigkeit und die EMV-Festigkeit sowie bezüglich einer elektrostatischen Entladung gerecht werden. Diese hohen Anforderungen sind bei bisher bekannten monolithischen Reglern nur durch eine Verwendung von externen Zusatzbauteilen erfüllbar. Eine Verbindung derartiger Zusatzbauteile mit dem monolithischen Regler ist bei bestehenden Montagekonzepten nur umständlich realisierbar. Unabhängig davon sind die Marktanforderungen nicht einheitlich. Die Anforderungen an die Auslegung des Reglers sind in starkem Maße abhängig vom jeweiligen Kraftfahrzeug, in welches der Regler eingebaut werden soll. Dies erschwert eine Herstellung von Reglern in großer Stückzahl erheblich.

### Vorteile der Erfindung

Die Erfindung betrifft einen monolithischen Regler gemäss dem Anspruch 1. Ein monolithischer Regler mit den Merkmalen des Anspruchs 1 ist in einfacher Weise an jeweils vorliegende Kundenanforderungen anpassbar. Will ein Kunde den monolithischen Regler in einer Umgebung einsetzen, in welcher die Anforderungen an die Impulsfestigkeit, die EMV-Festigkeit und die elektrostatische Entladung (ESD-Festigkeit) vergleichsweise niedrig sind, dann kann diesem Kunden der monolithische Regler, der in unverpackter Form auf dem Substrat befestigt ist, ohne Zusatzbauteile zur Verfügung gestellt werden. Dies hält den Preis für den monolithischen Regler vergleichsweise niedrig. Will ein anderer Kunde den monolithischen Regler in einer Umgebung einsetzen, in welcher die Anforderungen an die Impulsfestigkeit, die EMV-Festigkeit und/oder die elektrostatische Entladung hoch sind, dann kann diesem anderen Kunden der monolithische Regler, der in unverpackter Form auf dem Substrat befestigt ist, mit einem oder mehreren Zusatzbauteilen zur Verfügung gestellt werden, die zur Erfüllung der genannten hohen Anforderungen notwendig sind. Dabei kann zur Herstellung beider vorgenannter Regler ein und dieselbe Fertigungslinie verwendet werden.

Dieselbe Fertigungslinie kann auch zur Herstellung bekannter monolithischer Regler verwendet werden, die mit einem Kühlkörper fest verbunden sind, wobei der Kühlkörper beispielsweise ein aus Kupfer bestehender massiver Block ist, dessen Abmessungen mit den Abmessungen des Substrats mit den elektrisch leitfähigen Verbindungen übereinstimmen.

Aus der EP 1 130 766 A ist ein monolithischer Regler zur Regelung einer Generatoreinheit eines Fahrzeugs bekannt, der mit einem Kühlkörper fest verbunden ist. Der Regler umfasst ein mit elektrischen Verbindungen versehenes thermisch leitfähiges Substrat, das auf dem Kühlkörper befestigt ist.

Das modulare Konzept eines monolithischen Reglers gemäß der Erfindung hat weiterhin den Vorteil, dass die jeweils benötigten Zusatzbauteile, die vorzugsweise SMD-Bauteile sind, einfach und preisgünstig auf dem Substrat befestigt werden können.

Vorzugsweise dienen auf dem Substrat angebrachte Bondpads zur elektrischen Kontaktierung eines jeweiligen SMD-Bauteils mit dem monolithischen Regler oder mit einem externen Bauteil. Die elektrische Kontaktierung eines SMD-Bauteils mit einem weiteren SMD-Bauteil erfolgt - um eine externe Verdrahtung einzusparen - über die elektrisch leitfähigen Verbindungen innerhalb des Substrats. Die elektrische Kontaktierung eines SMD-Bauteils mit dem monolithischen Regler erfolgt über Leiter, die nicht Bestandteil des Substrats sind, also über eine externe Verdrahtung. Auch die elektrische Kontaktierung eines SMD-Bauteils mit Bauteilen, die nicht auf dem Substrat befestigt sind, erfolgt über Leiter, die nicht Bestandteil des Substrats sind.

Der monolithische Regler ist mit seiner Rückseite auf dem Substrat befestigt, beispielsweise geklebt oder gelötet. Diejenigen Bereiche des Substrats, auf welchen der monolithische Regler befestigt ist, können frei von elektrisch leitfähigen Verbindungen sein. Die elektrische Kontaktierung des monolithischen Reglers mit einem der SMD-Bauteile oder anderen Komponenten erfolgt über auf der Vorderseite des monolithischen Reglers vorgesehene Bondpads unter Verwendung von Leitern bzw. feinen Drähten, die außerhalb des Substrats verlaufen.

Weitere vorteilhafte Eigenschaften der Erfindung ergeben sich aus deren nachfolgender Erläuterung anhand der Zeichnung.

### Zeichnung

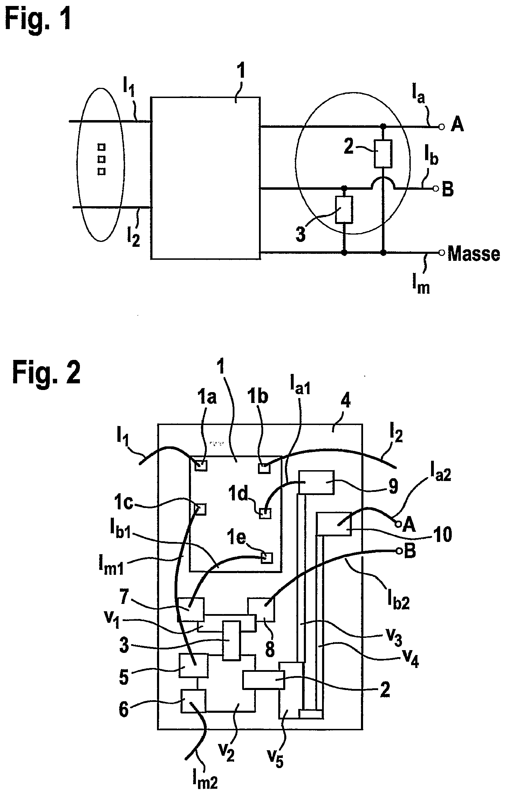

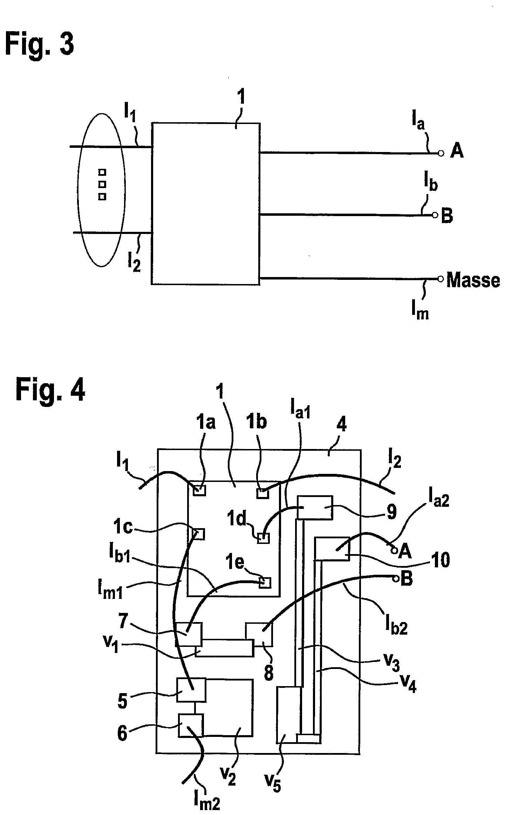

Die Figur 1 zeigt ein Blockschaltbild zur Veranschaulichung eines ersten Ausführungsbeispiels für die Erfindung. Die Figur 2 zeigt eine Skizze zur Veranschaulichung des mechanischen Aufbaus der in der Figur 1 gezeigten Schaltung. Die Figur 3 zeigt ein Blockschaltbild zur Veranschaulichung eines zweiten Ausführungsbeispiels für die Erfindung. Die Figur 4 zeigt eine Skizze zur Veranschaulichung des mechanischen Aufbaus der in der Figur 3 gezeigten Schaltung.

### Beschreibung

Die Figur 1 zeigt ein Blockschaltbild zur Veranschaulichung eines ersten Ausführungsbeispiels für die Erfindung. Gemäß diesem Ausführungsbeispiel ist ein monolithischer Regler 1 über Anschlussleitungen l₁, ..., l₂ mit einer nicht gezeichneten Generatoreinheit verbunden. Weiterhin ist der monolithische Regler 1 über eine Anschlussleitung lₐ mit einem Anschlusspunkt A, über eine Anschlussleitung l_{b} mit einem Anschlusspunkt B und über eine Anschlussleitung lₘ mit Masse verbunden. Zwischen die Anschlussleitung lₐ und die Anschlussleitung lₘ ist eine erste Zusatzkomponente 2 geschaltet. Zwischen die Anschlussleitung l_{b} und die Anschlussleitung lₘ ist eine zweite Zusatzkomponente 3 geschaltet. Der monolithische Regler 1 beinhaltet die gesamte Funktionalität eines Reglers für eine Generatoreinheit, also auch einen Treiber und eine Freilaufdiode. Der monolithische Regler 1 liegt in Form eines unverpackten Chips vor, insbesondere eines unverpackten Siliziumchips.

Bei den Zusatzkomponenten 2 und 3 handelt es sich um außerhalb des monolithischen Reglers 1 angeordnete diskrete Zusatzbauteile, die dazu vorgesehen sind, dass die gesamte Vorrichtung eine hohe Impulsfestigkeit und eine hohe EMV-Festigkeit aufweist sowie hohen Anforderungen bezüglich elektrostatischer Entladung gerecht wird. Derartige Zusatzbauteile sind insbesondere Kondensatoren, Widerstände und Dioden, die miteinander verschaltet sind.

Über die Anschlusspunkte A und B ist der Kabelbaum eines Kraftfahrzeugs angeschlossen, welcher über die Anschlussleitung lₐ den monolithischen Regler 1 mit Steuersignalen versorgt und über die Anschlussleitung l_{b} Datensignale vom monolithischen Regler 1 erhält. Diese Datensignale enthalten Informationen über den momentanen Zustand der Generatoreinheit oder beeinflussen das Regelverhalten.

Die Figur 2 zeigt eine Skizze zur Veranschaulichung des erfindungsgemäßen mechanischen Aufbaus der in der Figur 1 gezeigten Schaltung. Der in unverpackter Form vorliegende monolithische Regler 1 ist mit seiner Rückseite auf einem Kühlkörper 4 befestigt, beispielsweise auf diesen geklebt oder gelötet. Bei diesem Kühlkörper 4 handelt es sich um ein thermisch leitendes Substrat, welches elektrisch leitfähige Verbindungen v₁, v₂, v₃, v₄, v₅ aufweist. Das Substrat besteht beispielsweise aus einem Keramikmaterial, wobei die leitfähigen Verbindungen v₁, v₂, v₃, v₄, v₅ auf das Keramikmaterial aufgebracht sind.

Derjenige Bereich des Kühlkörpers 4, auf dem der monolithische Regler 1 befestigt ist, trägt keine elektrisch leitfähigen Verbindungen.

Die elektrische Kontaktierung des monolithischen Reglers 1 mit der Generatoreinheit erfolgt über die Leitungen l₁, ..., l₂, von denen in der Figur 2 die Leitungen l₁ und l₂ dargestellt sind. Ein Ende der Leitung l₁ ist an einem auf der Vorderseite des monolithischen Reglers 1 vorgesehenen Bondpad 1a befestigt. Die Leitung l₁ verläuft außerhalb des Kühlkörpers 4 und ist mit diesem elektrisch nicht kontaktiert. Ein Ende der Leitung l₂ ist am Bondpad 1b des monolithischen Reglers 1 befestigt. Die Leitung l₂ verläuft ebenfalls außerhalb des Kühlkörpers 4 und ist mit diesem elektrisch nicht kontaktiert.

Weiterhin ist der monolithische Regler 1 über sein Bondpad 1c und eine Leitung lₘ₁ mit einem auf dem Kühlkörper 4 angebrachten Bondpad 5 verbunden. Die Leitung Iₘ₁ verläuft außerhalb des Kühlkörpers 4. Das Bondpad 5 steht elektrisch in Verbindung mit der elektrisch leitfähigen Verbindung v₂. Diese wiederum steht elektrisch in Verbindung mit einem weiteren, auf dem Kühlkörper 4 angebrachten Bondpad 6, von welchem aus eine Leitung lₘ₂ nach Masse führt. Die Leitung lₘ₂ verläuft außerhalb des Kühlkörpers 4.

Die elektrisch leitfähige Verbindung v₂ ist weiterhin mit einem Anschluss der Zusatzkomponente 3 verbunden. Der andere Anschluss dieser Zusatzkomponente 3 ist mit der elektrisch leitfähigen Verbindung v₁ kontaktiert. Diese wiederum steht elektrisch mit weiteren Bondpads 7 und 8 in Verbindung, die jeweils auf dem Kühlkörper 4 angebracht sind. Zwischen dem Bondpad 7 und dem Bondpad 1e des monolithischen Reglers 1 verläuft eine Leitung l_{b1}. Zwischen dem Bondpad 8 und dem externen Anschlusspunkt B verläuft eine Leitung l_{b2}. Die Leitungen l_{b1} und l_{b2} verlaufen außerhalb des Kühlkörpers 4.

Die elektrisch leitfähige Verbindung v₂ ist ferner mit einem Anschluss der Zusatzkomponente 2 verbunden. Der andere Anschluss dieser Zusatzkomponente 2 ist mit der elektrisch leitfähigen Verbindung v₅ verbunden. Diese wiederum ist über die elektrisch leitfähige Verbindung v₃ mit einem Bondpad 9 und über die elektrisch leitfähige Verbindung v₄ mit einem Bondpad 10 verbunden. Die Bondpads 9 und 10 sind auf dem Kühlkörper 4 angebracht. Aus Platzgründen können die Verbindungen v₃ und v₄ alternativ zum dargestellten Ausführungsbeispiel zu einer Verbindung zusammengefasst sein. Das Bondpad 9 steht weiterhin über eine Leitung lₐ₁ mit dem Bondpad 1d des monolithischen Reglers 1 in Verbindung, wobei die Leitung lₐ₁ außerhalb des Kühlkörpers 4 verläuft. Das Bondpad 10 steht weiterhin über eine Leitung lₐ₂ mit dem externen Anschlusspunkt A in Verbindung, wobei die Leitung lₐ₂ außerhalb des Kühlkörpers 4 verläuft.

Die in der Figur 2 gezeigten Zusatzkomponenten 2 und 3 sind jeweils in Form eines SMD-Bauteils realisiert. Bei den elektrisch leitfähigen Verbindungen v₁, v₂ und v₅, auf welchen die SMD-Bauteile angebracht sind, handelt es sich um Aufnahmeelemente für SMD-Bauteile. Diese Aufnahmeelemente sind flächenmäßig größer als es für die Aufnahme der in der Figur 2 gezeigten SMD-Bauteile 2 und 3 nötig ist. Dies hat den Vorteil, dass beim Vorliegen anderer Anforderungen an die Impulsfestigkeit, die EMV-Festigkeit und das ESD-Verhalten anstelle der Bauteile 2 und 3 auch andere Bauteile eingesetzt werden können, deren Abmessungen sich von den Bauteilen 2 und 3 unterscheiden.

Gemäß der in der Figur 2 dargestellten Anordnung sind folglich sowohl der monolithische Regler 1 als auch die Zusatzkomponenten 2 und 3 auf dem Kühlkörper befestigt. Bei diesem handelt es sich um ein mit elektrisch leitfähigen Verbindungen v₁, v₂, v₃, v₄, v₅ versehenes thermisch leitfähiges Substrat, welches Kupferstrukturen oder elektrisch leitfähigen Pastendruck aufweist. Diese elektrisch leitfähigen Verbindungen sind mit auf dem Substrat 4 angebrachten Bondpads 5, 6, 7, 8, 9, 10 kontaktiert. Das Substrat ist beispielsweise ein Keramiksubstrat. Die Zusatzkomponenten 2 und 3 sind jeweils zwischen zwei der elektrisch leitfähigen Verbindungen angeordnet. Auf diese Weise wird eine elektrische Verschaltung erreicht, die mit der in der Figur 1 gezeigten elektrischen Verschaltung übereinstimmt.

Die Figur 3 zeigt ein Blockschaltbild zur Veranschaulichung eines zweiten Ausführungsbeispiels für die Erfindung. Bezüglich des in der Figur 3 dargestellten Reglers liegen weniger hohe Anforderungen an die Impulsfestigkeit, die EMV-Festigkeit und das ESD-Verhalten vor als bei dem in der Figur 1 gezeigten Regler. Folglich ist bei dem in der Figur 3 dargestellten Ausführungsbeispiel zwischen dem monolithischen Regler 1 und den Anschlüssen A, B und Masse keine Zusatzbeschaltung notwendig. Mit der Generatoreinheit ist der monolithische Regler 1 ebenso wie bei dem in der Figur 1 gezeigten Ausführungsbeispiel über die Leitungen l₁, ..., l₂ verbunden.

Die Figur 4 zeigt eine Skizze zur Veranschaulichung des mechanischen Aufbaus der in der Figur 3 gezeigten Schaltung. Der Aufbau gemäß der Figur 4 stimmt mit dem Aufbau gemäß der Figur 2 weitestgehend überein. Er unterscheidet sich von dem in der Figur 2 gezeigten Aufbau lediglich dadurch, dass die Zusatzkomponenten 2 und 3 fehlen. Folglich besteht bei dem in der Figur 4 gezeigten Ausführungsbeispiel keinerlei elektronischer Kontakt zwischen den leitfähigen Verbindungen v₁ und v₂ und auch keinerlei elektrischer Kontakt zwischen den leitfähigen Verbindungen v₂ und v₅.

Gemäß der Figur 4 ist das Bondpad 1e des monolithischen Reglers 1 über die Leitung l_{b1}, das Bondpad 7, die elektrisch leitfähige Verbindung v₁, das Bondpad 8 und die Leitung l_{b2} mit dem externen Anschlusspunkt B elektrisch verbunden. Diese Verbindung entspricht der Verbindung l_{b} in der Figur 3.

Weiterhin ist gemäß der Figur 4 das Bondpad 1c des monolithischen Reglers 1 über die Leitung lₘ₁, das Bondpad 5, die elektrisch leitfähige Verbindung v₂, das Bondpad 6 und die Leitung lₘ₂ mit Masse verbunden. Diese Verbindung entspricht der Verbindung lₘ in der Figur 3.

Ferner ist gemäß der Figur 4 das Bondpad 1d des monolithischen Reglers 1 über die Leitung lₐ₁, das Bondpad 9, die elektrisch leitfähige Verbindung v₃, die elektrisch leitfähige Verbindung v₅, die elektrisch leitfähige Verbindung v₄, das Bondpad 10 und die Leitung lₐ₂ mit dem externen Anschlusspunkt A verbunden. Diese Verbindung entspricht der Verbindung lₐ in der Figur 3.

Ein wesentlicher Vorteil der Erfindung besteht darin, dass die in den Figuren dargestellten Vorrichtungen mittels ein und derselben Fertigungslinie hergestellt werden können. Wünscht ein Kunde eine Herstellung von Reglern ohne hohe Anforderungen an die Impulsfestigkeit, die EMV-Festigkeit und das elektrostatische Verhalten, dann kann für diesen Kunden eine Vorrichtung gemäß der Figur 4 hergestellt werden, die keine Zusatzkomponenten aufweist. Für andere Kunden, die den Regler in einer Umgebung einsetzen möchten, in der hohe Anforderungen an die Impulsfestigkeit, die EMV-Festigkeit und das elektrostatische Verhalten vorliegen, können mittels derselben Fertigungslinie Vorrichtungen gemäß der Figur 2 hergestellt werden, die die Zusatzkomponenten 2 und 3 aufweisen, wobei letztere in Form von SMD-Bauteilen realisiert sind. Weiterhin können mit derselben Fertigungslinie auch Regler nach dem Stand der Technik hergestellt werden, bei deren Kühlkörper es sich beispielsweise um einen aus Kupfer bestehenden massiven Block handelt, der nicht mit einzelnen Leiterstrukturen versehen ist.

Um Kosten einzusparen kann alternativ zu dem in der Figur 4 gezeigten Ausführungsbeispiel die Bondbelegung optimiert werden.

## Patentansprüche

1. Monolithischer Regler für die Generatoreinheit eines Kraftfahrzeugs, der mit einem Kühlkörper (4) fest verbunden ist und der Kühlkörper (4) ein mit elektrisch leitfähigen Verbindungen (v1, v2, v3, v4, v5) versehenes, thermisch leitfähiges Substrat ist, auf dem der monolithische Regler (1) in unverpackter Form mit dem Substrat fest verbunden ist, **dadurch gekennzeichnet, dass** der monolithische Regler (1) mit mindestens einem zusätzlichen Bauteil elektrisch kontaktiert ist, bei welchem es sich um ein mit dem Substrat fest verbundenes SMD-Bauteil (2, 3) handelt, das mit den elektrisch leitfähigen Verbindungen (v1, v2, v3, v4, v5) verbunden ist, wobei die elektrisch leitfähigen Verbindungen (v1, v2, v3, v4, v5) flächenmäßig größer sind als es für die Aufnahme des wenigstens einen SMD-Bauteils (2, 3) erforderlich wäre.

2. Monolithischer Regler nach Anspruch 1, **dadurch gekennzeichnet, dass** er mit seiner Rückseite mit dem Substrat (4) verbunden ist.

3. Monolithischer Regler nach Anspruch 1 oder 2, **dadurch gekennzeichnet, dass** die elektrisch leitfähigen Verbindungen Kupferstrukturen sind oder aus leitfähigem Pastendruck bestehen.

4. Monolithischer Regler nach Anspruch 2 oder 3, **dadurch gekennzeichnet, dass** er auf seiner Vorderseite mit zur elektrischen Kontaktierung vorgesehenen Bondpads (1a, 1b, 1c, 1d, 1e) versehen ist.

5. Monolithischer Regler nach einem der vorhergehenden Ansprüche, **dadurch gekennzeichnet, dass** auf dem Substrat zwei SMD Bauteile (2, 3)vorgesehen sind und dass diese SMD-Bauteile (2, 3) über die elektrisch leitfähige Verbindung (v2) des Substrats (4) elektrisch miteinander kontaktiert sind.

6. Monolithischer Regler nach einem der Ansprüche 2 - 5, **dadurch gekennzeichnet, dass** die Querschnittsfläche des Substrats (4) größer ist als die Querschnittsfläche des monolithischen Reglers (1).

7. Monolithischer Regler nach einem der Ansprüche 5 oder 6, **dadurch gekennzeichnet, dass** er über eines der auf seiner Vorderseite vorgesehenen Bondpads (1a, 1b, 1c, 1d, 1e), eine Leitung (lm1, la1, lb1), die nicht Bestandteil des Substrats (4) ist, und eines der auf dem Substrat (4) vorgesehenen Bondpads (5, 6, 7, 8, 9, 10) mit einem der SMD-Bauteile (2, 3) elektrisch kontaktiert ist.

## Claims

1. A monolithic controller for the generator unit of a motor vehicle, which monolithic controller is fixedly connected to a cooling body (4) and the cooling body (4) is a thermally conductive substrate which is provided with electrically conductive connections (v1, v2, v3, v4, v5) and on which the monolithic controller (1) is fixedly connected to the substrate in unpackaged form, **characterised in that** the monolithic controller (1) is in electrical contact with at least one additional component which is an SMD component (2, 3) which is fixedly connected to the substrate and which is connected to the electrically conductive connections (v1, v2, v3, v4, v5), wherein the electrically conductive connections (v1, v2, v3, v4, v5) are larger in surface area than would be necessary to receive the at least one SMD component (2, 3).

2. The monolithic controller as claimed in claim 1, **characterised in that** it is connected by its rear side to the substrate (4).

3. The monolithic controller as claimed in claim 1 or 2, **characterised in that** the electrically conductive connections are copper structures or consist of conductive paste printing.

4. The monolithic controller as claimed in claim 2 or 3, **characterised in that** it is provided on its front side with bond pads (1a, 1b, 1c, 1d, 1e) provided for electrical contacting purposes.

5. The monolithic controller as claimed in any one of the preceding claims, **characterised in that** two SMD components (2, 3) are provided on the substrate and that these SMD components (2, 3) are in electrical contact with each other via the electrically conductive connection (v2) of the substrate (4).

6. The monolithic controller as claimed in any one of claims 2-5, **characterised in that** the cross-sectional area of the substrate (4) is larger than the cross-sectional area of the monolithic controller (1).

7. The monolithic controller as claimed in any one of claims 5 or 6, **characterised in that** it is in electrical contact with one of the SMD components (2, 3) via one of the bond pads (1a, 1b, 1c, 1d, 1e) provided on its front side, a lead (lm1, la1, lb1), which is not a part of the substrate (4), and one of the bond pads (5, 6, 7, 8, 9, 10) provided on the substrate (4).

## Revendications

1. Régulateur monolithique pour le groupe générateur d'un véhicule automobile, lequel régulateur est solidement fixé à un corps de refroidissement (4) et le corps de refroidissement (4) est un substrat thermiquement conducteur, muni de connexions électriquement conductrices (v1, v2, v3, v4, v5), sur lequel le régulateur monolithique (1) est solidement fixé au substrat sous une forme non mise sous boîtier, **caractérisé en ce que** le régulateur monolithique (1) est électriquement en contact avec au moins un composant supplémentaire qui est un composant SMD (2, 3) solidement fixé au substrat et relié aux connexions électriquement conductrices (v1, v2, v3, v4, v5), dans lequel les connexions électriquement conductrices (v1, v2, v3, v4, v5) sont plus grandes en termes de surface que celle qui serait requise pour recevoir le au moins un composant SMD (2, 3).

2. Régulateur monolithique selon la revendication 1, **caractérisé en ce qu'**il est relié au substrat (4) par sa face arrière.

3. Régulateur monolithique selon la revendication 1 ou 2, **caractérisé en ce que** les connexions électriquement conductrices sont des structures en cuivre ou sont constituées d'une pâte d'impression conductrice.

4. Régulateur monolithique selon la revendication 2 ou 3, **caractérisé en ce qu'**il est muni, au niveau de sa face avant, de plots de connexion (1a, 1b, 1c, 1d, 1e) prévu pour le contact électrique.

5. Régulateur monolithique selon l'une des revendications précédentes, **caractérisé en ce que** deux composants SMD (2, 3) sont prévus sur le substrat et **en ce que** ces composants SMD (2, 3) sont électriquement en contact les uns avec les autres via la connexion électriquement conductrice (v2) du substrat (4).

6. Régulateur monolithique selon l'une des revendications 2 à 5, **caractérisé en ce que** la surface de section transversale du substrat (4) est plus grande que la surface de section transversale du régulateur monolithique (1).

7. Régulateur monolithique selon l'une des revendications 5 ou 6, **caractérisé en ce qu'**il est électriquement en contact avec l'un des composants SMD (2, 3) via l'un des plots de connexion (1a, 1b, 1c, 1d, 1e) prévus sur sa face avant, un fil (lm1, la1, lb1) qui ne fait pas partie du substrat (4) et l'un des plots de connexion (5, 6, 7, 8, 9, 10) prévus sur le substrat (4).
